(19) Europäisches Patentamt
European Patent Office
Office européen des brevets

(11) **EP 2 912 501 B1**

(12) **EUROPÄISCHE PATENTSCHRIFT**

(45) Veröffentlichungstag und Bekanntmachung des Hinweises auf die Patenterteilung:
**19.12.2018 Patentblatt 2018/51**

(21) Anmeldenummer: **13789717.9**

(22) Anmeldetag: **15.10.2013**

(51) Int Cl.:
*G02B 1/11* *(2015.01)*      *G02B 5/22* *(2006.01)*
*G02B 5/00* *(2006.01)*

(86) Internationale Anmeldenummer:
**PCT/EP2013/071501**

(87) Internationale Veröffentlichungsnummer:
**WO 2014/063954 (01.05.2014 Gazette 2014/18)**

(54) **LICHT ABSORBIERENDES SCHICHTSYSTEM UND DESSEN HERSTELLUNG SOWIE DAFÜR GEEIGNETES SPUTTERTARGET**

LIGHT-ABSORBING LAYER SYSTEM, THE PRODUCTION THEREOF AND SPUTTER TARGET SUITABLE THEREFOR

SYSTÈME MULTICOUCHE ABSORBANT LA LUMIÈRE ET SA FABRICATION AINSI QUE CIBLE DE PULVÉRISATION APPROPRIÉE À CET EFFET

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **23.10.2012   DE 102012110113**
**20.12.2012   DE 102012112739**
**20.12.2012   DE 102012112742**

(43) Veröffentlichungstag der Anmeldung:
**02.09.2015   Patentblatt 2015/36**

(73) Patentinhaber:
• **Materion Advanced Materials Germany GmbH**
**63755 Alzenau (DE)**
• **Fraunhofer-Gesellschaft zur Förderung der angewandten Forschung e.V.**
**80686 München (DE)**

(72) Erfinder:
• **SCHLOTT, Martin**
**63075 Offenbach (DE)**

• **KASTNER, Albert**
**63457 Hanau (DE)**
• **SCHULTHEIS, Markus**
**36103 Flieden (DE)**
• **WAGNER, Jens**
**60322 Frankfurt (DE)**
• **SCHNEIDER-BETZ, Sabine**
**63150 Heusenstamm (DE)**
• **SZYSZKA, Bernd**
**38108 Braunschweig (DE)**
• **DEWALD, Wilma**
**38106 Braunschweig (DE)**

(74) Vertreter: **Kador & Partner PartG mbB**
**Corneliusstraße 15**
**80469 München (DE)**

(56) Entgegenhaltungen:
**EP-A1- 0 852 266      EP-A1- 2 116 631**
**EP-A1- 2 336 811      EP-A2- 2 416 185**
**US-A1- 2004 115 362      US-A1- 2010 313 875**

## Beschreibung

Technischer Hintergrund

Die vorliegende Erfindung betrifft ein Licht absorbierendes Schichtsystem aus mindestens zwei Schichten, von denen eine einem Betrachter zugewandte Antireflexschicht ist, die aus einem dielektrischen Werkstoff besteht und mindestens eine weitere eine dem Betrachter abgewandte Absorberschicht aus einem Oxid oder aus einem Oxinitrid mit unterstöchiometrischem Sauerstoffgehalt ist.

Weiterhin betrifft die Erfindung ein Verfahren zur Herstellung eines derartigen Schichtsystems, umfassend die Abscheidung einer Absorberschicht durch DC- oder MF-Sputtern eines Sputtertargets in einer Sputter-Atmosphäre, die ein Edelgas enthält.

Darüber geht es in der Erfindung um ein zur Durchführung des Verfahrens geeignetes Sputtertarget.

Stand der Technik

Licht absorbierende Schichtsysteme werden beispielsweise durch Abscheiden aufeinanderfolgender Schichten durch Kathodenzerstäubung (Sputtern) erzeugt. Dabei werden Atome oder Verbindungen aus einem Festkörper, dem Sputtertarget, durch Beschuss mit energiereichen Ionen (üblicherweise Edelgasionen) herausgelöst und gehen in die Gasphase über. Die in der Gasphase befindlichen Atome oder Moleküle werden schließlich durch Kondensation auf einem in der Nähe des Sputtertargets befindlichen Substrat abgeschieden und bilden dort eine Schicht aus. Beim "Gleichspannungssputtern" oder "DC-Sputtern" (direct current sputtering) wird zwischen dem als Kathode geschalteten Target und einer Anode (häufig das Anlagengehäuse) eine Gleichspannung angelegt. Durch Stoßionisation von Inertgasatomen bildet sich im evakuierten Gasraum ein Niederdruckplasma, dessen positiv geladene Bestandteile durch die angelegte Gleichspannung als dauerhafter Teilchenstrom in Richtung auf das Target beschleunigt werden und beim Aufprall Teilchen aus dem Target herausgeschlagen, die sich wiederum in Richtung auf das Substrat bewegen und sich dort als Schicht niederschlagen.

Das DC-Sputtern erfordert ein elektrisch leitfähiges Targetmaterial, da sich andernfalls das Target infolge des dauerhaften Stroms elektrisch geladener Teilchen aufladen und damit das Gleichspannungsfeld kompensieren würde. Andererseits ist gerade diese Sputtermethode geeignet, Schichten besonders hoher Qualität auf wirtschaftliche Weise zu liefern, so dass ihr Einsatz angestrebt wird. Dies trifft auch für das technologisch verwandte MF-Sputtern zu, bei dem zwei Sputtertargets wechselseitig im kHz-Rhythmus als Kathode und Anode geschaltet werden.

Licht absorbierende Schichtsysteme werden für verschiedene Anwendungen eingesetzte, wie etwa für solarthermische Anwendungen oder sogenannte "black matrix"-Schichten in Verbindung mit Flüssigkristall-Displays.

Bei den Solarabsorberschichten umfasst der Schichtaufbau typischerweise eine Cermetschicht und eine darunter liegende metallische Abschlussschicht, die als selektiver Reflektor dient. Die in die Cermetschicht eingelagerten leitfähigen oder metallischen Partikel haben Durchmesser von typischerweise 5-30 nm. Diese Schichtstapel weisen im solaren Spektralbereich einen hohen Absorptionsgrad auf, während ihr Absorptionsgrad im infraroten Spektralbereich gering ist. Für ihre industrielle Fertigung sind galvanische Beschichtungstechniken und ebenfalls PVD-Verfahren gebräuchlich. Beispiele für solche Schichtstapel sind Ni/NiO + Al und TiNx/TiO$_2$ + Cu. Eine aktuelle Übersicht gibt "Kennedy, C.E.; - Review of Midto High-Temperature Solar Selective Absorber Materials; NREL Technical Report (July 2002)".

Die als selektiver Reflektor dienende metallische Abschlussschicht zeigt eine hohe Absorption. Wegen ihrer gleichzeitig hohen elektrischen Leitfähigkeit wirkt sie jedoch stark dämpfend für darunter verlaufende Signalleitungen hochfrequenter elektronischer Schaltungen und ist daher für Anwendungen im Bereich der Hochfrequenztechnik oder überall dort, wo im Schichtsystem außerdem Signale schnell geschaltet werden müssen, nicht geeignet.

Es sind auch "Cermet-Schichtsysteme" bekannt, bei denen Bereiche aus metallischer Phase in einer oxidischen Matrix eingelagert sind. Derartige Cermet-Schichtsystem sind jedoch schwierig ätzbar, da Oxid und eingebettete Metallpartikel unterschiedliche Ätzmittel benötigen. So wird beispielsweise bei Kombinationen aus einem Oxid und einem Edelmetall bei fluoridischem Ätzen oder mit KOH und H$_2$O$_2$ überwiegend das Oxid geätzt, so dass Metallpartikel übrig bleiben und damit die Sputteranlage und nachfolgende Substrate kontaminieren.

Die vor allem bis zur Substratgeneration 5 eingesetzten Cr-basierten "black matrix Schichten" weisen außerdem den Nachteil auf, dass beim nasschemischen Ätzen giftige Cr-VI Verbindungen entstehen können.

Ein bekanntes Schichtsystem wird in EP2336811 und ein bekanntes Sputtertarget in EP0852266 offenbart.

Technische Aufgabenstellung

Aus den oben erörterten Gründen sind Schichtstrukturen erwünscht, die eine hohe Absorption und geringe Reflektion im sichtbaren Spektralbereich und eine geringe Wechselwirkung mit elektronischen Bauteilen und Signalleitungen zeigen, die also eine möglichst geringe elektrische Leitfähigkeit haben und sich außerdem ohne das Entstehen giftiger Substanzen und ohne Partikelrückstände ätzen lassen. Metallische Schichten oder Schichtlagen erfüllen diese Voraussetzung nicht. Andererseits - und dazu im gewissen Widerspruch stehend - sollen die Schichten aus Qualitätserwägungen vorzugsweise durch DC- oder MF-Sputtern herstellbar sein, was einen elektrisch leitenden Target-Werkstoff voraussetzt.

Der Erfindung liegt daher die Aufgabe zugrunde, ein Schichtsystem und ein für seine Herstellung geeignetes Sputtertarget bereitzustellen, die diese Anforderungen erfüllen.

Weiterhin liegt der Erfindung die Aufgabe zugrunde, ein Verfahren mit hoher Prozessstabilität anzugeben, das eine reproduzierbare Herstellung des erfindungsgemäßen Schichtsystems ermöglicht.

Allgemeine Beschreibung der Erfindung

Das erfindungsgemäße Schichtsystem

Hinsichtlich des Schichtsystems wird diese Aufgabe ausgehend von einem Schichtsystem der eingangs genannten Gattung erfindungsgemäß dadurch gelöst, dass die Absorberschicht aus einem Oxid oder aus einem Oxinitrid mit jeweils unterstöchiometrischem Sauerstoffgehalt besteht, wobei das Schichtsystem insgesamt im Wellenlängenbereich von 380 bis 780 nm eine visuelle Transmission Tv von weniger als 20 %, eine visuelle Reflexion Rv von weniger als 6 % und einen Schichtwiderstand RY von mehr als 10 k Ohm aufweist.

Das Schichtsystem soll für einen Betrachter optisch nicht transparent, also undurchsichtig erscheinen. Dies erfordert eine starke Absorption im sichtbaren Spektralbereich von 380-780 nm, jedoch nicht bis hinauf zu 1.500 nm, wie sie mit metallischen Schichtlagen erreichbar ist. Zumindest in der vom Betrachter aus gesehen hinteren Schichtlage - der Absorberschicht - ist eine geringe visuelle Transmission Tv von weniger als 20 %, vorzugsweise weniger als 10 % im Wellenlängenbereich von 380 bis 780 nm zu gewährleisten.

Licht absorbierende Schichten können durch lichtstreuende oder absorbierende Einlagerungen von Partikeln oder Ausscheidungen in einer ansonsten transparenten Schichtmatrix erhalten werden. Werden derartige Schichten im weiteren Fertigungsprozess einem Ätzvorgang unterworfen, können jedoch Partikel oder Ausscheidungen ein anderes Ätzverhalten zeigen als die Schichtmatrix und beim Ätzen des Schichtsystems zu einer unerwünschten Partikelbildung führen. Dies ist insbesondere bei schwer ätzbaren Metallpartikeln der Fall, wie etwa bei Edelmetallpartikeln.

Um dies zu vermeiden, ist beim erfindungsgemäßen Schichtsystem vorgesehen, dass die Absorberschicht lichtabsorbierend wirkt, indem sie aus einem unterstöchiometrischen Oxid oder einem unterstöchiometrischen Oxinitrid besteht. Diese Substanzen haben unbesetzte O- oder N-Valenzen. Im Fall des Oxinitrids können diese sowohl als Stickstoff- als auch als Sauerstoffmangel interpretiert werden. Sofern nicht ausdrücklich anderes gesagt wird, soll der Einfachheit halber bei den folgenden Erläuterungen ein "unterstöchiometrischer Stickstoffgehalt" mitgelesen werden, auch wenn auf "Unterstöchiometrie" allgemein oder auf "unterstöchiometrischen Sauerstoffgehalt" oder "Sauerstoffmangel" Bezug genommen wird.

Weitab ihrer stöchiometrischen Zusammensetzung vorliegende Substanzen zeigen eine Anzahl von Sauerstoffmangeldefekten, die sich spektroskopisch anhand einer spezifischen oder verschwommenen Absorption im sichtbaren Wellenlängenbereich äußern. Dadurch wird die Absorberschicht allein durch den Sauerstoffmangel im Wellenlängenbereich von 380 bis 780 nm optisch undurchlässig, ohne dass dafür kristalline Partikel oder Ausscheidungen erforderlich sind.

Um nicht nur eine hohe Absorption, sondern zugleich auch eine geringe Reflexion zu erreichen, hat das Schichtsystem jedoch mindestens zwei Schichtlagen. Die Absorberschicht befindet sich unmittelbar oder mittelbar - über eine Zwischenschicht - auf einer Antireflexschicht. Diese dient im Wesentlichen als "Reflexionsanpassungsschicht". Ihr Brechungsindex liegt vorzugsweise zwischen dem Brechungsindex des an sie unmittelbar angrenzenden Mediums, wie etwa einem Substrat oder Luft und an dem Brechungsindex der Absorberschicht oder einer etwaigen Zwischenschicht. Ihre Dicke ist so einzustellen, dass die visuelle Reflexion Rv des Schichtsystems weniger als 6 %, vorzugsweise weniger als 2 %, beträgt. Die Antireflexschicht hat über ihre Schichtdicke einen homogenen Brechungsindex oder einen Brechungsindex-Gradienten.

Als visuelle Reflexion Rv wird dabei die auf Augenempfindlichkeit normierte Reflexion verstanden, die aus der Gesamtreflexion des Schichtsystems berechnet wird. Zur Berechnung der visuellen Reflexion Rv werden die Messwerte des Spektrometers mit den genormten Faktoren der Augenempfindlichkeit gefaltet und aufintegriert beziehungsweise summiert. Diese Faktoren der Augenempfindlichkeit sind in der DIN EN 410 festgelegt.

Ist das Schichtsystem auf einem transparenten Substrat aufgebracht, wird zur Berechnung der visuellen Reflexion noch der Reflexionswert an der nicht beschichteten Oberfläche des Substrates abgezogen.

Als visuelle Transmission Tv wird dementsprechend die auf Augenempfindlichkeit normierte Transmission verstanden, die aus der Gesamt-Transmission des Schichtsystems berechnet wird. Die Berechnung der visuellen Transmission Tv erfolgt ebenfalls anhand der Messwerte des Spektrometers, wie in der DIN EN 410 festgelegt.

Darüber hinaus weist das Schichtsystem insgesamt eine geringe elektrische Leitfähigkeit auf, die charakterisiert ist durch einen Schichtwiderstand RY von mehr als 10 k Ohm, vorzugsweise mehr als 20 k Ohm. Dadurch werden Wechselwirkungen mit elektronischen Bauteilen oder Leiterbahnen in unmittelbarer Nähe vermieden. Der hohe Schichtwiderstand wird dadurch erreicht, dass die Schichten des Schichtsystems oxidischer oder oxinitridrischer Natur sind. Der Schichtwiderstand des Schichtstapels von Antireflexschicht und Absorberschicht wird mit der Vierpunkt-Methode auf der Oberfläche der Absorberschicht gemessen.

Das Schichtsystem kann beispielsweise auf elektronische Bauteile und Leitungen aufgebracht sein, um diese abzudecken und für den Betrachter unsichtbar zu machen. In dem Fall können die elektronischen Bauteile und Leitungen oder deren Substrate oder Platinen gleichzeitig als Träger für die Schichtstruktur dienen, wobei die Absorberschicht dem Träger näher liegt als die Antireflexschicht.

Bei einer anderen Ausführungsform ist die Antireflexschicht auf einem Substrat aus lichtdurchlässigem Werkstoff aufgebracht, das in dem Fall als Träger dient. Hierbei liegt die Antireflexschicht dem Träger näher als die Absorberschicht. Üblicherweise handelt es sich bei dem Substrat um eine Glasplatte, einen KunststoffTräger oder eine Folie. Auf die Antireflexschicht folgt unmittelbar oder über eine oder mehrere Zwischenschichten die Absorberschicht, die mit weiteren funktionalen Schichten versehen sein kann.

Wesentliche Funktion der Absorberschicht ist die Erzeugung einer möglichst hohen Absorption der über die Antireflexschicht einfallenden optischen Strahlung. Parameter zur Erfüllung dieser Funktion sind außer dem Werkstoff der Absorberschicht ihre Schichtdicke und der Grad des Sauerstoffmangels. Je größer die Schichtdicke und der Sauerstoffmangel sind, umso höher sind elektrische Leitfähigkeit und Absorptionsvermögen der Absorberschicht. Diese Parameter werden auf einen optimalen Kompromiss zwischen hoher Absorption des Schichtsystems einerseits und einer niedrigen elektrischen Leitfähigkeit andererseits ausgelegt. Hinsichtlich des Werkstoffs hat es sich als vorteilhaft erwiesen, wenn die Absorberschicht als Hauptkomponente Oxide der Metalle Nb, Ti, Mo, W, V oder deren Mischungen enthält.

Diese Oxide und die daraus abgeleiteten stickstoffhaltigen Oxinitride zeigen bei Sauerstoffmangel (im Fall von Oxinitriden auch als Stickstoffmangel zu interpretieren) eine ausgeprägte Absorption im sichtbaren Wellenlängenbereich. Diese Werkstoffe haben außerdem den Vorteil, dass unterstöchiometrische Phasen nicht dazu neigen, schwer ätzbare Strukturen, wie kristalline Ausscheidungen, Segregations-Strukturen oder Metallcluster zu bilden.

In dem Zusammenhang ist es besonders vorteilhaft, wenn die Absorberschicht eine optisch homogene Struktur hat in dem Sinne, dass sie keine mittels Röntgendiffraktometermessungen erfassbaren kristallinen Strukturen aufweist.

Hiermit ergibt sich dann auch ein homogenes Ätzverhalten, wie beispielsweise beim Ätzen mit Fluorid-Ionen oder Ansätzen auf der Basis von KOH+$H_2O_2$. Die so charakterisierten Schichten zeigen auch bei transelektronenmikroskopischer Betrachtung keine Strukturen bis hinunter zu der Auflösungsgrenze von 2 nm. Thermodynamisch ist die amorphe Struktur jedoch instabil, so dass sich durch Tempern oder Aufheizen kristalline Ausscheidungen bilden können.

Für die Ausbildung der dielektrischen Antireflexschicht kommen grundsätzlich und bevorzugt dieselben Substanzen in Betracht wie für die Absorberschicht, jedoch dann mit voller Stöchiometrie oder allenfalls mit einem weniger ausgeprägten Sauerstoffmangel. Es hat sich sogar als vorteilhaft erwiesen, wenn auch die Antireflexschicht einen gewissen Sauerstoffmangel aufweist, wobei der Sauerstoffgehalt aber mindestens 94 % des stöchiometrischen Sauerstoffgehalts beträgt. Dadurch erzeugt nicht nur die Absorberschicht, sondern auch die Antireflexschicht eine gewisse Absorption, so dass die Gesamtdicke des Schichtsystems zur Gewährleistung der erforderlichen Gesamt-Absorption geringer gehalten werden kann.

Es sind aber auch andere, in der Literatur zur Antireflexbeschichtung eingesetzte dielektrische Schichtsysteme geeignet, beispielsweise AIN, $SnO_2$, $Si_3N_4$, $HfO_2$, ZnO, $TiO_2$, $Al_2O_3$, Siliciumoxinitrid, $Nb_2O_5$, $MoO_3$, $WO_3$, $V_2O_5$ oder deren Mischungen.

Die Funktion der Antireflexschicht, nämlich die Reflexion des einfallenden Lichts im sichtbaren Wellenlängenbereich möglichst gering zu halten, wird vorteilhafterweise dadurch erfüllt, dass sie auf einem Substrat aufgebracht ist und einen Brechungsindex $n_R$ hat, für den gilt: $n_S < n_R < n_A$, wobei $n_S$ der Brechungsindex des Substrats und $n_A$ der Brechungsindex der Absorberschicht sind.

Obwohl es technisch einfacher ist, eine Doppelschicht aus Antireflexschicht und Absorberschicht auszuführen, ist auch ein Aufbau des Schichtsystems aus mehreren, in ihrer Sauerstoff-Unterstöchiometrie abgestuften Schichten oder auch eine Gradientenschicht möglich, die in Blickrichtung des Betrachters aus gesehen kontinuierlich sauerstoffärmer wird.

Das erfindungsgemäße Schichtsystem zeichnet sich vorzugsweise durch einen Absorptionsindex kappa im Bereich von 0,7 bis 0,8.bei einer Wellenlänge von 550 nm aus.

Für den Absorptionsindex kappa gilt hierbei:

$$n*kappa=k,$$

mit k=Extinktionskoeffizient, der wiederum in die komplexe Brechzahl

$$N=n+i*k$$

eingeht und mittels dem ein Dämpfungsbeitrag durch den Imaginärteil im Brechungsindex der Schichten des Schichtsystems berücksichtigt wird.

Nur im Hinblick auf eine Absorberschicht mit möglichst hoher Absorption, gibt es grundsätzlich keine definierte Obergrenze für kappa. Allerdings kann bei sehr hohen kappa-Werten oberhalb von 2,5 eine effektive Entspiegelung der Absorberschicht zunehmend schwieriger werden.

Ein optimaler Kompromiss zwischen möglichst hoher optischer Absorption einerseits und geringer elektrischer Leitfähigkeit (Hochohmigkeit) der Absorberschicht andererseits ergibt sich, wenn der Sauerstoffgehalt der Absorberschicht zwischen 65 und 90 %, vorzugsweise zwischen 70 und 85 % des stöchiometrischen Sauerstoffgehalts beträgt.

Der Absorberschicht fehlen dabei zwischen 10 und 35 %, vorzugsweise zwischen 15 und 30 % der Sauerstoffatome, die in einer voll stöchiometrischen, dielektrischen Schicht anzutreffen wären. Mit zunehmendem Sauerstoffmangel innerhalb der hinteren Schicht nimmt deren Leitfähigkeit zu. Bei hohen Sauerstoffdefiziten oberhalb von 35 % kann der Widerstand auf unvorteilhaft niedrige Werte sinken.

Mit zunehmender Dicke nimmt der elektrische Widerstand der Absorberschicht ab und die Absorption nimmt zu. Im Sinne eines möglichst hohen elektrischen Widerstandes und ausreichend hohem Absorptionsvermögen hat die Absorberschicht eine Dicke von weniger als 250 nm, vorzugsweise im Bereich von 70 bis 160 nm.

Im Sinne einer möglichst geringen Reflexion in Gegenrichtung zum einfallenden Licht und einer guten Reflexionsanpassung an die Absorberschicht hat die Antireflexschicht eine Dicke von weniger als 50 nm, vorzugsweise im Bereich von 30 bis 45 nm.

Im Hinblick auf die Herstellkosten ist die Gesamtdicke des Schichtsystems so klein wie möglich, um eine vorgegebene maximale Transmission einzuhalten. Wesentliche Parameter sind dabei der Sauerstoffmangel und die Dicke der Absorberschicht. Die erforderliche Mindestdicke kann durch Versuche einfach ermittelt werden. Typischerweise liegt die Gesamtdicke von Antireflexschicht und Absorberschicht im Bereich von 80 nm bis 300 nm, bevorzugt im Bereich von 100 nm bis 200 nm.

### Das erfindungsgemäße Sputtertarget

In gewissem Widerspruch zur erwünschten geringen elektrischen Leitfähigkeit des Schichtsystems steht die Anforderung, die Schichten durch DC- oder MF-Sputtern herstellen zu können, was ein elektrisch leitfähiges Targetmaterial voraussetzt. Dieses Erfordernis könnte am einfachsten durch Einsatz metallischer Targets erreicht werden, wobei der Sauerstoffmangel der Absorberschicht sich beispielsweise durch teilreaktives Sputtern der Metalltargets unter unterschiedlichen Sauerstoffzugaben einstellen ließe. Dies erfordert jedoch eine exakte und konstante Einstellung des Sauerstoffgehalts in der Target-Umgebung, was häufig mit einer geringen Prozessstabilität einhergeht und insbesondere bei großflächigen Beschichtungen an technologische Machbarkeitsgrenzen stößt.

Die beiden obigen Randbedingungen hinsichtlich Eigenschaft und Herstellung der Absorberschicht sind erfüllbar, wenn als Sputtertarget ein solches eingesetzt wird, das einen Sauerstoffmangel aufweist, der entweder durch eine reduzierte Oxidphase von unterstöchiometrischem und dadurch elektrisch leitfähigem Oxid oder Oxinitrid auf der Basis von $Nb_2O_{5-x}$, $TiO_{2-x}$, $MoO_{3-x}$, $WO_{3-x}$, $V_2O_{5-x}$ (x>0) oder deren Mischungen allein oder durch die reduzierte Oxidphase zusammen mit einer metallischen Beimischung eingestellt wird.

Die Oxide oder Nitride des Sputtertargets weisen einen Mangel an Sauerstoff oder Stickstoff im Vergleich zur stöchiometrischen Zusammensetzung auf. Damit ist das Sputtertarget auch ohne elektrisch leitende Phase oder schon bei einem geringen Anteilen derselben ausreichend elektrisch leitfähig, so dass es mittels DC- oder MF-Sputtern verarbeitet werden kann. Zu diesem Zweck beträgt sein spezifischer elektrischer Widerstand vorzugsweise weniger als 10 Ohm*cm und besonders bevorzugt weniger als 1 Ohm*cm.

Im erfindungsgemäßen Sputtertarget ist der Sauerstoffmangel des erfindungsgemäßen Schichtsystems im Wesentlichen bereits angelegt, indem der Sauerstoffmangel des Sputtertargets dem der jeweilig zu sputternden Schicht genau oder in etwa entspricht. Beim Sputtern sind die oben genannten unterstöchiometrischen Oxide oder Nitride in der Lage Sauerstoff oder Stickstoff aufzunehmen. Eine Feinjustierung der Schichtstöchiometrie kann somit durch geringe Zugaben an Reaktivgasen (insbesondere von Sauerstoff) erreicht werden, so dass die erwähnten technologischen Schwierigkeiten beim Absputtern von Metalltargets unter hochreaktiver Atmosphäre vermieden werden. Neben Sauerstoff ist auch die Zugabe anderer reaktiver Gase wie Stickstoff geeignet.

Der unterstöchiometrische Sauerstoffgehalt kann im Sputtertarget entweder allein durch unterstöchiometrisches Metalloxid eingestellt werden oder dadurch, dass stöchiometrische oder nur geringfügig unterstöchiometrisches und damit elektrisch leitfähiges Metalloxid zusätzlich mit metallischem Material vermischt wird. Die letztgenannte Ausführungsform ist in der Regel zu bevorzugen, da stark unterstöchiometrische Oxide mit bis 35 % Sauerstoffmangel schwer darstellbar sind. Die metallische Beimischung enthält bevorzugt mindestens eines der Elemente Nb, Ti, Mo, W, Ta und V.

Der Sauerstoffmangel des Sputtertargets ist vorzugsweise durch einen Reduktionsgrad definiert, bei dem der Sauerstoffgehalt zwischen 65 und 90 %, besonders bevorzugt zwischen 70 und 85 % des stöchiometrischen Sauerstoffgehalts, beziehungsweise des stöchiometrischen Sauerstoff- und Stickstoffgehalts liegt.

Ein derartiges Sputtertarget zeichnet sich durch einen geringen elektrischen Widerstand aus, der vorteilhafterweise weniger als 10 Ohm*cm, bevorzugt weniger als 1 Ohm*cm beträgt.

Dabei hat es sich bewährt, wenn die metallische Beimischung mindestens 50%, vorzugsweise mindestens 70% zur Einstellung der Unterstöchiometrie der Absorberschicht beiträgt.

Beim Sputtern geben reduzierbare oxidische oder nitridische Bestandteile des Target-Werkstoffs Sauerstoff oder Stickstoff an die metallische Beimischung ab. Letztendlich wird ein vorgegebener Sauerstoff-Unterschuss in der abgeschiedenen Schicht eingestellt. Der Anteil der metallischen Beimischung im Target-Werkstoff ist so ausgelegt, dass er 50 % oder mehr dieses Unterschusses ausmacht.

Besonders gute Ergebnisse werden für die Absorberschicht erhalten, wenn der Target-Werkstoff Nb und Mo sowie mindestens eines deren Oxide, vorzugsweise Nioboxid mit unterstöchiometrischem Sauerstoffgehalt enthält.

Eine besonders bevorzugte Ausführungsform des erfindungsgemäßen Sputtertargets besteht aus $Nb_2O_{5-x}$ und Mo mit x=0,01 - 0,3, wobei der Mo-Gehalt vorzugsweise zwischen 28 und 60 Gew.-%, besonders bevorzugt zwischen 36 und 50 Gew.-%, beträgt.

Bei einer alternativen und ebenfalls geeigneten Ausführungsform des Sputtertargets enthält dieses Ti und Mo sowie mindestens eines deren Oxide, wobei der Mo-Gehalt vorzugsweise zwischen 30 und 65 Gew.-%, bevorzugt zwischen 40 und 55 Gew.-%, beträgt.

Es hat sich als vorteilhaft erwiesen, wenn der Reduktionsgrad über die Dicke des Sputtertargets möglichst gleichbleibend ist. Daher weist das unterstöchiometrische Oxid oder Oxinitrid bevorzugt einen Reduktionsgrad auf, der an mindestens 5 Stellen über die Dicke des Sputtertargets gemessen um nicht mehr als +-5 % (relativ) um einen Mittelwert streut.

Der Reduktionsgrad wird gemessen, indem mindestens fünf Proben mit einem Gewicht von 1 g aus unterschiedlichen Dickenbereichen der Targetschicht genommen und an diesen Proben die Gewichtszunahme bei Reoxidation bei 1000°C an Luft ermittelt wird. Der Mittelwert ergibt sich als arithmetisches Mittel der gemessenen Gewichtszunahmen.

Der homogene Reduktionsgrad trägt zu einer hohen Prozessstabilität beim Sputterprozess und zur Erzeugung von Sputterschichten mit reproduzierbaren Eigenschaften bei.

Im Hinblick hierauf hat es sich auch bewährt, wenn die metallische Beimischung einen Metallgehalt definiert, der an mindestens 5 Stellen über die Dicke des Sputtertargets gemessen um nicht mehr als +-5 % (relativ) um einen Mittelwert streut.

In Bezug auf das Verfahren zur Herstellung des erfindungsgemäßen Schichtsystems wird die oben angegebene Aufgabe ausgehend von einem Verfahren der eingangs genannten Gattung erfindungsgemäß durch ein Verfahren gelöst, bei dem ein Sputtertarget mit einem Sauerstoffmangel gemäß der Erfindung eingesetzt wird, wobei zur Abscheidung einer Absorberschicht aus einem Oxid oder aus einem Oxinitrid mit unterstöchiometrischem Sauerstoffgehalt der Sputter-Atmosphäre ein Reaktivgas in Form von Sauerstoff und/oder Stickstoff beigemischt wird, derart, dass sich in der Sputter-Atmosphäre ein Reaktivgasgehalt von maximal 10 Vol.-%, bevorzugt maximal 5 Vol.-% einstellt.

Das erfindungsgemäße Verfahren zeichnet sich aus durch das Zusammenspiel einer nur wenig reaktiven Sputter-Atmosphäre einerseits und des Einsatzes eines Targets aus unterstöchiometrischem Oxid oder Oxinitrid andererseits. Die abgeschiedene Schicht unterscheidet sich in ihrer chemischen Zusammensetzung nicht wesentlich von der des eingesetzten Target-Materials. Dies erlaubt eine stabile Führung des Sputterprozesses und die reproduzierbare Einstellung der Eigenschaften der abgeschiedenen Schicht.

Dazu trägt auch eine besonders bevorzugte Modifikation dieser Verfahrensweise bei, bei der- jeweils bezogen auf ideale Stöchiometrie der Anteil an Sauerstoff und Stickstoff im Material des Sputtertargets gleich groß oder nur wenig kleiner ist als der Anteil an Sauerstoff und Stickstoff im Oxid oder Oxinitrid der Absorberschicht, wobei der Anteil im Material des Sputtertargets mindestens 50 %, bevorzugt mindestens 70 % des Anteils in der Absorberschicht ausmacht..

Sowohl das Material des Sputtertargets insgesamt, also seine oxidische oder oxinitridische Phase und unter Berücksichtigung eines etwaigen Beitrags einer metallische Beimischung, als auch die herzustellende Absorberschicht zeigen einen Mangel an Sauerstoff oder Stickstoff - im Vergleich zu einem vollstöchiometrischen Material. Beim erfindungsgemäßen Verfahren ist vorgesehen, dass der Mangel an Sauerstoff im Targetmaterial so groß ist, oder nur geringfügig ausgeprägter ist als der Mangel an Sauerstoff in der Absorberschicht. Genauer gesagt, liegt der Anteil an Sauerstoff und Stickstoff im Material des Sputtertargets bei mindestens 50 %, bevorzugt bei mindestens 70 % des Anteils an Sauerstoff/Stickstoff in der Absorberschicht.

Dadurch ist das Targetmaterial unverändert oder mit nur geringer Aufoxidation in das unterstöchiometrische Oxid/Oxinitrid der Absorberschicht übertragbar. Dabei ist zu beachten, dass ein gewisser Sauerstoffverlust beim Sputterprozess einen kleinen Beitrag zur Einstellung der gewünschten Unterstöchiometrie der Absorberschicht liefern kann.

Bei einer besonders einfachen Verfahrensweise erfolgt die Abscheidung der Antireflexschicht und der Absorberschicht unter Einsatz derselben Target-Zusammensetzung, wobei die Sputter-Atmosphäre bei der Abscheidung der Antireflexschicht einen höheren Reaktivgasgehalt hat als bei der Abscheidung der Absorberschicht.

Die Reaktivgaszugabe bei der Abscheidung der Antireflexschicht ist dabei ausreichend hoch, dass die Antireflexschicht dielektrisch wird.

Ausführungsbeispiel

Nachfolgend wird die Erfindung anhand einer Patentzeichnung und eines Ausführungsbeispiels näher erläutert. Im Einzelnen zeigt:

**Figur 1**   eine schematische Darstellung des erfindungsgemäßen Schichtsystems in einem Querschnitt,
**Figur 2**   eine elektronenmikroskopische Aufnahme eines Schliffs des Schichtsystems,
**Figur 3**   eine TEM-Aufnahme des Schliffs in maximaler Vergrößerung,
**Figur 4**   ein Röntgenbeugungsdiagramm des Werkstoffs des Schichtsystems,
**Figur 5**   ein Diagramm zur spektralen Transmission und Reflexion des Schichtsystems, gemessen von der Substratseite aus,
**Figur 6**   eine Arbeitskurve für die Herstellung von $NbO_x$-Sputterschichten in einer Sputteranlage unter Einsatz metallischer Sputtertargets, und
**Figur 7**   Transmissionskurven von $NbO_x$-Schichten.

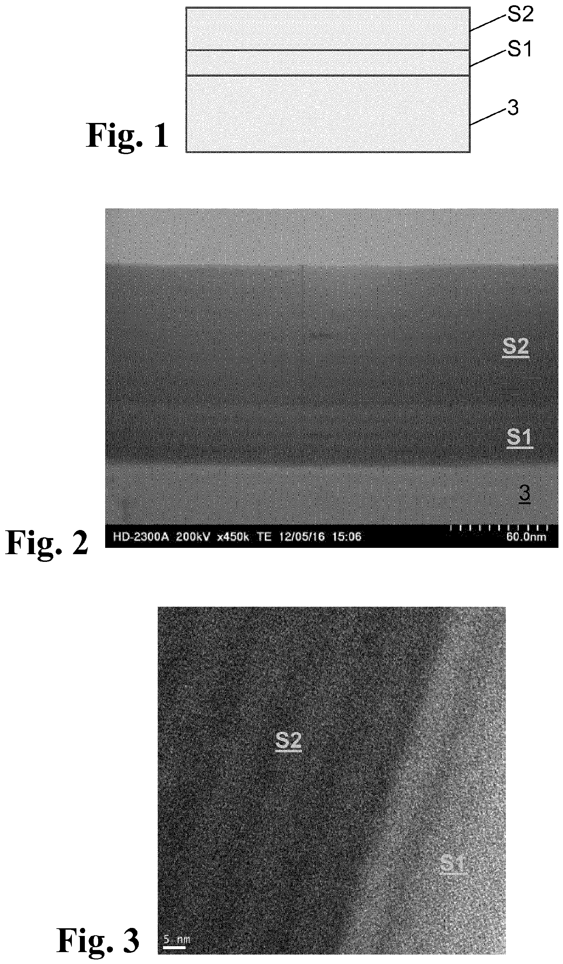

**Figur 1** zeigt schematisch ein aus zwei Schichten S1, S2 bestehendes Schichtsystem 1 gemäß der Erfindung. Die erste Schicht ist eine auf einer transparenten Glasplatte 3 aufgebrachte Antireflexschicht S1, und die zweite Schicht ist eine auf der Antireflexschicht S1 erzeugte Absorberschicht S2

Die Schichten S1 und S2 bestehen jeweils aus einer Oxidschicht mit unterschiedlichem Sauerstoffmangel. Das Oxid enthält mindestens eines der Elemente Nb, Ti, V, Mo, W.

Der Sauerstoffgehalt der Antireflexschicht S1 liegt bei mindestens 94 % des stöchiometrischen Sauerstoffgehalts. Der Sauerstoffgehalt der Absorberschicht S2 ist geringer und liegt im Bereich von 65 bis 90 % des stöchiometrischen Sauerstoffgehalts. Der Sauerstoffgehalt der Schichten wird mittels EPMA-Messungen (Electron Probe Microscope Analysis) ermittelt. Dabei wird ein Elektronenstrahl auf die Probe gerichtet und die dabei erzeugte Röntgenstrahlung analysiert. Es kann gegen Standards kalibriert werden, so dass der relative Messfehler etwa bei 3-4%, liegt und der Sauerstoffgehalt der unterstöchiometrischen Schicht auf etwa +-1 At.% bestimmt werden kann. Um keine Messfehler durch das Substrat zu erhalten, sind hierfür am besten Schichten mit >1 µm Dicke herzustellen.

Das Schichtsystem ist für einen Betrachter mit Blickrichtung von der Glasplatte 3 aus nahezu undurchsichtig und zugleich fast schwarz. **Figur 2** zeigt die entsprechende Schichtstruktur 1 als elektronenmikroskopische Aufnahme der Probe 3 von Tabelle 1. Die Schichtdicke der Antireflexschicht S1 beträgt 40 nm und die Schichtdicke der Absorberschicht S2 beträgt 90 nm. Im Ausführungsbeispiel wurde die Schicht S1 von einem Target gesputtert, das neben $Nb_2O_{4,99}$ noch 5 Vol.-% (entspricht 10,7 Gew.-%) Mo enthält, während S2 von einem Target gesputtert wurde, das neben $Nb_2O_{4,99}$ noch 20 Vol.-% (entspricht 36,2 Gew.-%) Mo enthält. Auch in der TEM-Aufnahme von **Figur 3** mit maximaler Auflösung sind keine Metallausscheidungen zu erkennen.

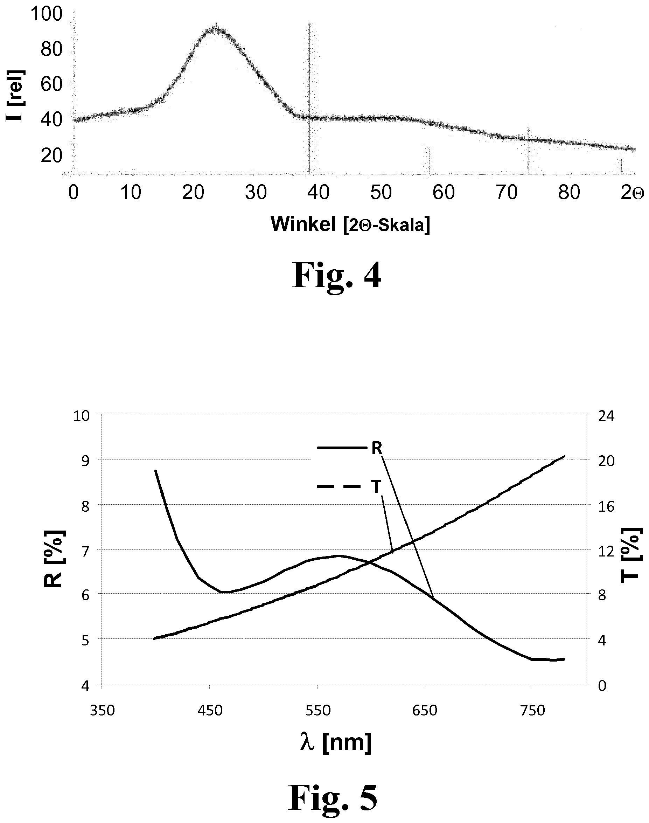

Dieses Ergebnis wird bestätigt durch das Röntgenbeugungsdiagramm der Schichtwerkstoffe in **Figur 4.** Es sind keine konkreten Beugungslinien zu erkennen, der Werkstoff ist röntgenamorph.

Aus **Tabelle 1** ergeben sich die jeweiligen Metallgehalte des eingesetzten Sputtertargets und Schichtdicken d der Schichten S1 und S2 für das Schichtsystem aus $Nb_2O_5$ mit Mo, sowie die Messwerte für die Transmission $T_V$ und die Reflexion $R_V$ (abzüglich 4 % für die Reflexion an der Vorderseite des unbeschichteten Glas-substrats).

**Tabelle 1**

| Nr | Matrix | Me tall | S1 Mo [Gew%] | S1 d [nm] | S2 Mo [Gew.-%] | S2 d [nm] | Rv [%] | Tv [%] | RΥ [kΩ] | Q |
|---|---|---|---|---|---|---|---|---|---|---|
| 1 | $Nb_2O_5$ | Mo | 10,7 | 40 | 36,2 | 110 | 2,6 | 9,1 | 33 | |
| 2 | $Nb_2O_5$ | Mo | 10,7 | 40 | 36,2 | 120 | 2,6 | 9,1 | 25 | |
| 3 | $Nb_2O_5$ | Mo | 10,7 | 40 | 36,2 | 90 | 2,6 | 9,0 | 7,8 | **) |
| 4 | $Nb_2O_5$ | Mo | 10,7 | 32 | 43,1 | 80 | 1,8 | 20,3 | 130 | *) |
| 5 | $Nb_2O_5$ | Mo | 10,7 | 32 | 43,1 | 119 | 7,5 | 10,4 | 84 | *) |
| 6 | $Nb_2O_5$ | Mo | - | - | 43,1 | 319 | - | - | 0,94 | *) |

(fortgesetzt)

| Nr | Matrix | Me tall | S1 Mo [Gew%] | S1 d [nm] | S2 Mo [Gew.-%] | S2 d [nm] | Rv [%] | Tv [%] | R$\Upsilon$ [k$\Omega$] | Q |
|---|---|---|---|---|---|---|---|---|---|---|
| 7 | $Nb_2O_5$ | Mo | 36,2 | 36 | 36,2 | 110 | 2,5 | 9,1 | 32 | |

Anmerkung zu Mo (Gew.-%): Bezieht sich auf den Gehalt an Mo-Metall im Target-Werkstoff. In der Schicht S2 bildet sich eine amorphe Struktur aus einem unterstöchiometrische Oxid Nb-Mo-$O_x$ mit nicht exakt bestimmbarer Aufteilung des Sauerstoffs auf Nb und Mo.

Die Qualität der Schichtsysteme wurde hinsichtlich ihrer spektralen Reflexion $R_V$, der spektralen Transmission $T_V$ und ihres elektrischen Schichtwiderstandes RY bewertet.

Das Ergebnis ist in Spalte "Q" angegeben. Dabei setzt sich die Symbolik der qualitativen Bewertung wie folgt um:

*) Schicht erfüllt die gestellten Anforderungen nicht

**) Schicht mit grenzwertigen Eigenschaften

Die Anforderungen sind: visuelle Transmission Tv < 20 % (im Wellenlängenbereich von 380 - 780 nm); visuelle Reflexion Rv v< 6 %, Schichtwiderstand R$\Upsilon$< 10 kOhm.

Nachfolgend wird ein Verfahren zur Herstellung der erfindungsgemäßen Schichtstruktur anhand eines Beispiels näher erläutert:

Beispiel 1

Eine Pulvermischung aus 89,3 Gew.-% $Nb_2O_{4,99}$ und 10,7 Gew.-% Mo mit einer mittleren Korngröße von 25 $\mu$m wird in einem Taumel-Mischer 1h lang intensiv gemischt, so dass sich eine feine und monodisperse Verteilung der Mo-Partikel in $Nb_2O_{4,99}$ ergibt. Anschließend wird diese Mischung in eine Graphitform mit einem Durchmesser von 75 mm und einer Höhe von 15 mm gefüllt. Die Ronde wird durch Heißpressen unter reduzierenden Bedingungen bei 1200°C und 30 MPa zu mehr als 85 % der theoretischen Dichte verdichtet. Das so erhaltene Gefüge besteht aus einer $Nb_2O_{4,99}$-Matrix, in die Mo-Partikel mit einer mittleren Korngröße von 25 $\mu$m eingebettet sind.

Analog wird ein zweites Sputtertarget mit 64 Gew.-% $Nb_2O_{4,99}$ und 36 Gew.-% Mo hergestellt. Dabei wurde zur Herstellung einer besondere geleichmäßigen Mo-Verteilung ein Mo-Pulver mit <10$\mu$m Korngröße gewählt.

Die Sputtertargets weisen einen spezifischen elektrischen Widerstand von weniger als 1 Ohm*cm auf.

Unter Verwendung dieser Sputtertargets wird die zweilagige Schichtstruktur S1, S2 auf einem Glassubstrat 3 der Größe 2 cm x 2 cm und einer Dicke von 1,0 mm mittels DC-Sputtern aufgebracht. Auf das Glassubstrat 3 wird zunächst eine 40 nm dicke erste Schicht S1, die 10,7 Gew.-% Molybdän enthält, aufgebracht und darauf anschließend eine 110 nm dicke zweite Schicht S2, die 36 Gew.-% Molybdän enthält.

Die Sputterparameter sind dabei wie folgt:

| | |
|---|---|
| Restgasdruck: | $2 * 10^{-6}$ mbar |
| Prozessdruck: | $3* 10^{-3}$ mbar bei 200 sccm Argon |
| Spezifische Kathodenleistung: | 5 W/cm$^2$ |
| Schicht S1: | Target: $Nb_2O_5$ + Mo 10,7 Gew.-%; d = 40 nm, zusätzlicher Sauerstoffstrom: 10 sccm. |
| Alternative Schicht S1: | Target: $Nb_2O_5$ + Mo 36 Gew.-%; d = 36 nm, zusätzlicher Sauerstoffstrom: 30 sccm. |
| Schicht S2: | Target: $Nb_2O_5$ + Mo 36 Gew.-%; d = 110 nm, zusätzlicher Sauerstoffstrom: 10 sccm. |

Beim Schichtsystem mit "alternativer Schicht S1" und "Schicht S2" wird nur eine Sputtertarget-Zusammensetzung zur Abscheidung beider Schichten benötigt. Die unterschiedlichen Sauerstoff-Stöchiometrien werden dabei nur durch den Sauerstoffstrom beim Sputtern eingestellt. Dabei entspricht ein Sauerstoffstrom von 30sccm (das sind im Ausführungsbeispiel 13 Vol.-% Sauerstoff in der Sputter-Atmosphäre) einem Sauerstoffstrom, der technologisch noch problemlos gefahren werden kann.

Die Schicht S1 ist unter diesen Bedingungen nahezu volloxidisch, während S2 in etwa den Sauerstoffmangel des Targets aufweist. Um voll dielektrische Schichten von einem volloxidischen Target zu erhalten, ist unter den gegebenen Bedingungen ein anlagenspezifischer Sauerstoffstrom erforderlich, um den Verlust an Sauerstoff durch die Pumpen auszugleichen. Der erforderliche Sauerstofffluss ergibt sich in erster Näherung aus dem Metallgehalt (Sauerstoffmangel) des eingesetzten Targets für diese Schicht. Für die eingesetzte Laboranlage und $Nb_2O_{4,99}$+Mo gilt näherungsweise:

$$\text{Sauerstoff-Fluss in sccm} = \text{Mo-Gehalt des Targets in Gew-\%.}$$

Für andere Sputteranlagen und Target-Mischungen ist der entsprechende Wert durch wenige Versuche zunächst zu ermitteln und der Sauerstofffluss dementsprechend anzupassen. Die so hergestellte Schichtstruktur zeichnet sich unter anderem durch folgende Eigenschaften aus:
• Schichtwiderstand: $R\Upsilon$ = 33 k$\Omega$/square
• Visuelle Reflexion (nach Abzug von ca. 4 % Reflexion durch Messung von

| | |
|---|---|
| der unbeschichteten Substratseite): | 2,6 %. |
| Visuelle Transmission: | 9,1 % |

Vorteilhafte Ausführungsformen des Schichtsystems mit qualitativer Bewertung der erhaltenen Schichteigenschaften sind in Tabelle 1 genannt.

Der Absorptionskoeffizient Kappa der hergestellten Schichtstruktur 1 liegt für die Wellenlänge 550 nm bei 0,75.

Die Absorption der $Nb_2O_5$-Mo-Schichtstruktur insgesamt liegt damit höher als 90 %. Die Farbe der produzierten Schichtsysteme wird unter Zugrundelegung des CIELab- Farbraummodells ermittelt. Beim "CIELab-Farbraum" werden die gemessenen Spektralkurven auf drei Koordinaten reduziert. Die Koordinatenachsen L*, a*, b* stehen rechtwinkelig aufeinander:

L* beschreibt die Helligkeit von 0 (reines Schwarz) bis 100 (reines Weiß).

a* stellt die Rot-Grün-Achse dar. Negative Werte sind grün, positive sind rot.

b* stellt die Gelb-Blau-Achse dar. Negative Werte sind blau, positive sind gelb.

Im CIELab-Farbraum bewegt sich a* im Bereich -1,8 bis +4; und b* zwischen 0 bis -4. Somit ist mit diesem Schichtsystem eine neutrale Reflexionsfarbe auf der unbeschichteten Substratseite einstellbar.

Für die gesamte Schichtstruktur 1 wird das spektrale Reflexionsvermögens und die spektralen Transmission bei Wellenlängen von etwa 380 bis 780 nm unter Verwendung eines UV-VIS-NIR-Spektrophotometers V-570DS von JASCO gemessen.

In **Figur 5** sind für das Schichtsystem Glas / Mo-NbOx / NbOx die Transmission T in [%] und die Reflexion R in [%] gegen die Messwellenlänge $\lambda$ in [nm] aufgetragen. Die Reflexion an der nicht entspiegelten Vorderseite des Glas-Substrats ist hier noch nicht abgezogen. Demnach liegt die Transmission T über einen breiten Wellenlängenbereich von 380 nm bis 780 nm unterhalb von 20 %. Die gemessene Reflexion liegt dabei unterhalb von 9%, so dass sich nach Abzug eines Reflexionswertes von 4 %, der auf Reflexion an der nicht entspiegelten Glasplatten-Vorderseite zurückzuführen ist, eine tatsächlich dem Schichtsystem zuzuschreibende Reflexion unterhalb von 5 % ergibt.

Bei Lagerung der Schichtstruktur bei 18-24°C und 50-60 % relativer Luftfeuchtigkeit über bis zu 5 Tage haben sich die optischen Eigenschaften nur unwesentlich verändert. Die Änderung von Rv und Tv lag jeweils unter einem Prozentpunkt.

Die so erzeugte Schicht lässt sich ohne Bildung störender Metallpartikel z.B. über Ätzen in Lösungen aus $KOH+H_2O_2$ strukturieren. Auch bei anderen Ätzverfahren, wie beispielsweise Sputterätzen, zeigt sich keinerlei störende Partikelbildung.

Beispiel 2

Zur Untersuchung des Einflusses der Sauerstoff-Stöchiometrie auf die optischen und elektrischen Eigenschaften wurden in einem weiteren Versuch Sputtertargets aus metallischem Niob in eine In-line Sputteranlage der Firma Leybold (Bezeichnung: A700V) eingebaut und mittels reaktivem DC-Sputtern Nioboxid-Schichten auf alkalifreiem Glas (AF32, Größe 50 x 50 mm$^2$) mit ca. 100 nm Schichtdicke bei unterschiedlichen Sauerstoffpartialdrücken hergestellt.

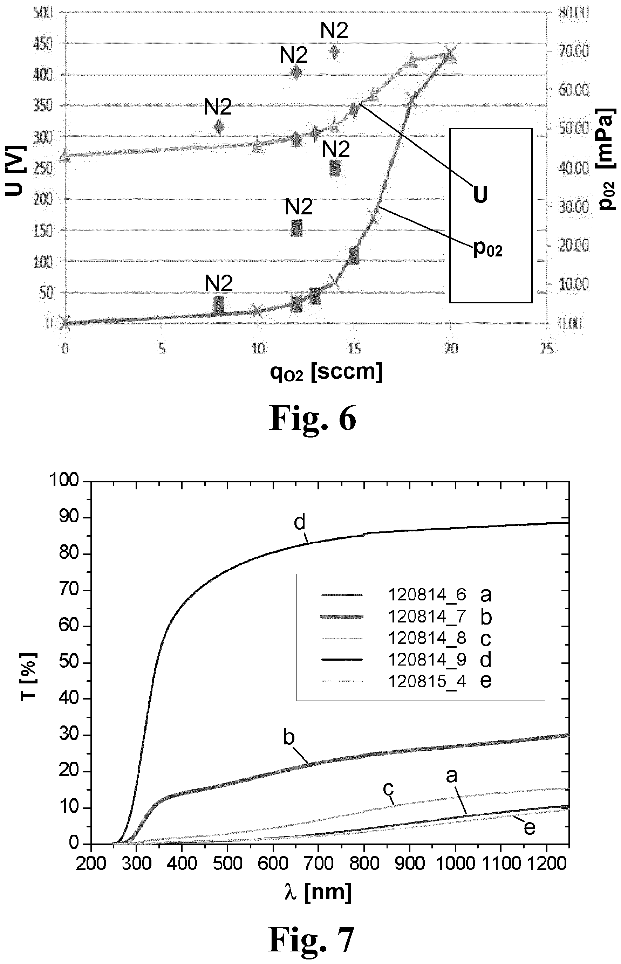

Im Diagramm von **Figur 6** ist auf der linken Ordinatenachse die Entwicklung der Generatorspannung U in [V] (obere Kurve U) und auf der rechten Ordinate der Sauerstoffpartialdruck $p_{O2}$ in [mPa] (untere Kurve $p_{O2}$) innerhalb der Sputterkammer in Abhängigkeit von der Sauerstoffzufuhr $q_{O2}$ in [sccm] aufgetragen. Demnach führt eine Sauerstoffzufuhr im Bereich von 18 bis 20 sccm entsprechend einem Sauerstoffpartialdruck um 60 bis 70 mPa zu einer Sättigung (voll-oxidischer Mode) und einem Maximum der Generatorspannung. Demnach reagiert das zur Abscheidung eingesetzte Metalltarget bei diesem Sauerstoffpartialdruck vollständig zu Nioboxid. Es werden demnach volloxidische $Nb_2O_5$-Schichten mit stöchiometrischem Sauerstoffgehalt erhalten. Bei einer Sauerstoffzufuhr von weniger als 15 sccm entsprechend einem Sauerstoffpartialdruck unterhalb von 20 mPa sind daher Schichten mit deutlich unterstöchiometrischem Sauerstoffgehalt zu erwarten, wie sie für die vorliegende Erfindung wesentlich sind.

Die zu den oben erläuterten Messungen gehörigen Messpunkte sind im Diagramm von Figur 6 eingetragen und liegen auf den beiden eingezeichneten Messkurven. Darüber hinaus sind - nur zum Vergleich - Messpunkte eingetragen, die Messungen zuzuordnen sind, bei denen ein geringer Teil (< 50 Vol.-%) des zugeführten Sauerstoffs durch Stickstoff ersetzt worden ist. Die dabei ermittelten Messwerte sind mit N2 gekennzeichnet; sie liegen durchweg oberhalb der Messkurven, die bei Zufuhr von reinem Sauerstoff erhalten worden sind. Bei einem Stickstoffanteil in der reaktiven Sputter-Atmosphäre wird in der atomaren Struktur der abgeschiedenen Schicht ein Teil des Sauerstoffs durch Stickstoffatome oder -moleküle ersetzt, so dass eine etwas geringere Sauerstoffzufuhr erforderlich ist, um eine vollständige Abreaktion des unterstöchiometrischen Targetmaterials zu bewirken. Der Arbeitspunkt für den Sputterprozess verschiebt sich allerdings bei gegebenem Sauerstofffluss zu höheren Kathodenspannungen.

Für einige charakteristische Proben der Figur 6 mit Nb-basierten Schichten sind in Tabelle 2 die Dispositionsparamater und die dazugehörigen Messergebnisse an den abgeschiedenen Schichten zusammengefasst.

## Tabelle 2 (Nb-basierte Schichten)

| Probe | Ar-Fluss [sccm] | $O_2$-Fluss [sccm] | $N_2$-Fluss [sccm] | $p(O_2)$ [mPa] | P [W] | U [V] | D [ nm] | RΥ [Ω] |
|---|---|---|---|---|---|---|---|---|
| 120814_6 | 150 | 12 | 0 | 4.75 | 1000 | 295 | 140 | 395 |
| 120814_7 | 150 | 15 | 0 | 17.3 | 1000 | 343 | 93 | 61000 |
| 120814_8 | 150 | 13 | 1 | 7 | 1000 | 304 | 122 | 1300 |
| 120814_9 | 150 | 14 | 10 | 40 | 1000 | 337 | ~50 | ∞ |
| 120815_3 | 150 | 12 | 5 | 24.5 | 1000 | 403 | 102 | ∞ |
| 120815_4 | 150 | 8 | 3.3 | -- | -- | -- | 160 | 560 |

Dabei bedeuten: P = Leistung und U=Generatorspannung der Sputteranlage, d=abgeschiedene Schichtdicke; RΥ steht für den gemessenen Schichtwiderstand.

Die Ergebnisse zeigen, dass sich auch durch die Zugabe von Stickstoff zur Sputter-Atmosphäre der Schichtwiderstand erhöht. Es hat sich aber gezeigt, dass in dem Fall der Volumenanteil für Stickstoff geringer sein sollte als der von Sauerstoff, und dass die Volumenanteile von Stickstoff und Sauerstoff insgesamt weniger als 10 Vol.-% betragen sollten. Andernfalls wird die Schicht zu transparent. Daher ist die Zugabe von Stickstoff zur Sputter-Atmosphäre zwecks Erhöhung des Schichtwiderstandes nur in gewissem Umfang sinnvoll.

Dies belegt auch das Diagramm von **Figur 7**, das Transmissionskurven für ausgewählte Proben der Tabelle 3 zeigt. Auf der Y-Achse ist die Transmission T in [%] aufgetragen gegen die Wellenlänge λ in [nm] im Bereich von 250 bis 1250 nm.

Demnach zeigen alle Schichten mit zunehmender Wellenlänge eine Zunahme der Transmission. Die Probe mit der Bezeichnung 120814_9 wird nahezu vollständig transparent. Bei dieser war dieser Probe war die Stickstoffzugabe beim Sputterprozess offenbar zu hoch.

Die Probe mit der Bezeichnung 120814_7 zeigt neben einem besonders hohen Schichtwiderstand (wie aus Tabelle 3 ersichtlich) auch eine ausreichend geringe visuelle Transmission von weniger als 30 % über den gesamten sichtbaren Wellenlängenbereich.

Analog wurden Schichten ausgehend von metallischen Wolfram- und Titantargets hergestellt. Die Beschichtungsparameter sind für die Titan-basierten Schichten in Tabelle 3 und für die wolframbasierten Schichten in Tabelle 4 aufgeführt.

## Tabelle 3 (Ti-basierte Schichten)

| Probe | Ar Fluss [sccm] | O$_2$ Fluss [sccm] | N$_2$ Fluss [sccm] | P(O$_2$) [mPa] | P [W] | U [V] | d [nm] | R$_\square$ [Ω] |
|---|---|---|---|---|---|---|---|---|
| 120815_1 | 150 | 6 | 0 | 1.92 | 1000 | 296 | 161 | 122.5 |
| 120815_2 | 150 | 7 | 0 | 2.25 | 1000 | 301 | 100 | 340 |
| 120815_5 | 150 | 6 | 3 | 10.25 | 1000 | 383 | -- | ∞ |
| 120815_6 | 150 | 3 | 1.4 | 0.57 | 1000 | 295 | 130 | 100 |
| 120815_7 | 150 | 4 | 2 | 1.03 | 1000 | 301 | 80 | 186 |
| 120815_8 | 150 | 5.5 | 2 | 5-7 | 1000 | 361 | ~10 | ∞ |
| 120815_9 | 150 | 4.5 | 2 | 1.32 | 1000 | 302 | 81 | 250 |
| 120815_10 | 150 | 5 | 2 | 1.77 | 1000 | 317 | 60 | 3530 |

## Tabelle 4 (W-basierte Schichten)

| Probe | Ar Fluss [sccm] | O$_2$ Fluss [sccm] | N$_2$ Fluss [sccm] | p(O$_2$) [mPa] | P [W] | U [V] | d [nm] | R$_\square$ [Ω] |
|---|---|---|---|---|---|---|---|---|
| 120814_1 | 150 | 50 | 0 | 140 | 1000 | 539 | 222 | ∞ |
| 120814_2 | 150 | 30 | 0 | 64.5 | 1000 | 482 | 224 | 730 |
| 120814_3 | 150 | 40 | 0 | 97 | 1000 | 518 | 104 | 710 |
| 120814_4 | 150 | 30 | 50 | 84 | 1000 | 530 | 46 | ∞ |
| 120814_5 | 125 | 25 | 25 | 60 | 1000 | 503 | 158.5 | 4800 |

Die Ergebnisse zeigen, dass sich aus diesen Materialsystemen nur schwer Schichten herstellen lassen, die gut absorbieren aber zugleich hochohmig sind.

Die im jeweiligen Materialsystem auf Basis von Nb, Ti und W optimalen Messproben sind in den Tabellen 2, 3 und 4 grau hinterlegt. Für diese Absorberschichten wurden durch Hinzufügen einer Antireflexschicht aus Nb$_2$O$_5$:Mo10,7 Gew.-% entspiegelte Schichtsysteme hergestellt. Die Messergebnisse für diese Ergebnisse sind in Tabelle 5 zusammengefasst.

### Tabelle 5

| Probe (S1 + S2) | d1 [nm] | d2 [nm] | Rv [%] | Tv [%] | R□ [kΩ] | Q |
|---|---|---|---|---|---|---|
| NbOx:Mo10,7 % + NbOx | 41 | 159 | 0.9 | 5,3 | 61 | |
| NbOx:Mo10,7 % + WOxNy | 33 | 167 | 2,5 | 13,8 | 4,8 | *) |
| NbOx:Mo10,7 % + TiOxNy | 32,5 | 167,5 | 1,6 | 9,5 | 3,5 | *) |
| *) Schicht erfüllt die gestellten Anforderungen nicht<br>Die Anforderungen sind: visuelle Transmission Tv < 20 % (im Wellenlängenbereich von 380 - 780 nm); visuelle Reflexion Rv v< 6 %, Schichtwiderstand Rϒ< 10 kOhm. | | | | | | |

**Tabelle 5** zeigt, dass die besten Eigenschaften hinsichtlich geringer Reflektivität und Transmission sowie hohem Schichtwiderstand mit dem System NbO$_x$:Mo10,7% + NbO$_x$ erzielbar sind. Die Systeme NbO$_x$:Mo10,7 Gew.-% + WO$_x$N$_y$ und NbO$_x$:Mo10,7 Gew.-% + TiOxNy zeigen zwar ausreichend gute optische Eigenschaften aber in der gegebenen Konfiguration einen zu geringen Schichtwiderstand. Durch Verringerung der Schichtdicke d2 ließe sich dieser zwar erhöhen, jedoch auf Kosten einer dann deutlich höheren und damit zu großen Transmission.

**Patentansprüche**

1. Licht absorbierendes Schichtsystem aus mindestens zwei Schichten auf einem Träger (3), von denen eine Schicht eine Antireflexschicht (S1) ist, die aus einem dielektrischen Werkstoff besteht und mindestens eine weitere eine Absorberschicht (S2) aus einem Oxid oder aus einem Oxinitrid mit unterstöchiometrischem Sauerstoffgehalt ist, wobei das Schichtsystem insgesamt im Wellenlängenbereich von 380 bis 780 nm eine visuelle Transmission Tv von weniger als 20 %, eine visuelle Reflexion Rv von weniger als 6 % aufweist,
**dadurch gekennzeichnet, dass**
das Schichtsystem einen Schichtwiderstand RΥ von mehr als 10 k Ohm aufweist.

2. Schichtsystem nach Anspruch 1, **dadurch gekennzeichnet, dass** das Schichtsystem insgesamt im Wellenlängenbereich von 380 bis 780 nm eine visuelle Transmission Tv von weniger als 10 %, eine visuelle Reflexion Rv von weniger als 2 % und einen Schichtwiderstand RΥ von mehr als 20 k Ohm aufweist.

3. Schichtsystem nach Anspruch 1 oder 2, **dadurch gekennzeichnet, dass** die Absorberschicht als Hauptkomponente Oxide der Metalle Nb, Ti, Mo, W, V oder deren Mischungen enthält.

4. Schichtsystem nach einem der vorhergehenden Ansprüche, **dadurch gekennzeichnet, dass** die Antireflexschicht als Hauptkomponente $Nb_2O_5$, $TiO_2$, $MoO_3$, $WO_3$, $V_2O_5$, AlN, $SnO_2$, ZnO, $Si_3N_4$, $HfO_2$, $Al_2O_3$, Siliciumoxinitrid oder deren Mischungen enthält und dass sie unmittelbar oder mittelbar auf einem Substrat aus lichtdurchlässigem Werkstoff aufgebracht ist und einen Brechungsindex $n_R$ hat, für den gilt: $n_S < n_R < n_A$, wobei $n_S$ der Brechungsindex des Substrats und $n_A$ der Brechungsindex der Absorberschicht sind, wobei der Sauerstoffgehalt der Antireflexschicht mindestens 94 % des stöchiometrischen Sauerstoffgehalts beträgt.

5. Schichtsystem nach einem der vorhergehenden Ansprüche, **gekennzeichnet durch** einen Absorptionsindex kappa im Bereich von 0,7 bis 0,8 bei einer Wellenlänge von 550 nm.

6. Schichtsystem nach einem der vorhergehenden Ansprüche, **dadurch gekennzeichnet, dass** der Sauerstoffgehalt der Absorberschicht zwischen 65 und 90 %, vorzugsweise zwischen 70 und 85 % des stöchiometrischen Sauerstoffgehalts beträgt.

7. Schichtsystem nach einem der vorhergehenden Ansprüche, **dadurch gekennzeichnet, dass** die Absorberschicht eine optisch homogene Struktur hat in dem Sinne, dass sie keine mittels Röntgendiffraktometermessungen erfassbaren kristallinen Strukturen aufweist.

8. Schichtsystem nach einem der vorhergehenden Ansprüche, **dadurch gekennzeichnet, dass** die Absorberschicht eine Dicke von weniger als 250 nm, vorzugsweise im Bereich von 70 bis 160 nm hat.

9. Schichtsystem nach einem der vorhergehenden Ansprüche, **dadurch gekennzeichnet, dass** die Antireflexschicht eine Dicke von weniger als 50 nm, vorzugsweise im Bereich von 30 bis 45 nm hat.

10. Schichtsystem nach einem der vorhergehenden Ansprüche, **dadurch gekennzeichnet, dass** die Gesamtdicke von Antireflexschicht und Absorberschicht im Bereich von 80 bis 300 nm, bevorzugt im Bereich von 100 bis 200 nm liegt.

11. Sputtertarget zur Herstellung eines Schichtsystems nach einem der Ansprüche 1 bis 10, **dadurch gekennzeichnet, dass** es einen Sauerstoffmangel aufweist, der durch eine reduzierte Oxidphase von unterstöchiometrischem und dadurch elektrisch leitfähigem Oxid oder Oxinitrid auf der Basis von $Nb_2O_{5-x}$, $TiO_{2-x}$, $MoO_{3-x}$, $WO_{3-x}$, $V_2O_{5-x}$ (x>0) oder deren Mischungen zusammen mit einer metallischen Beimischung eingestellt wird, wobei das Sputtertarget entweder Nb und Mo sowie mindestens eines deren Oxide enthält oder Ti und Mo sowie mindestens eines deren Oxide enthält.

12. Sputtertarget nach Anspruch 11, **dadurch gekennzeichnet, dass** der Sauerstoffmangel durch einen Reduktionsgrad definiert ist, bei dem der Sauerstoffgehalt zwischen 65 und 90 %, vorzugsweise zwischen 70 und 85 % des stöchiometrischen Sauerstoffgehalts liegt.

**13.** Sputtertarget nach Anspruch 11 oder 12, **dadurch gekennzeichnet, dass** sein elektrischer Widerstand weniger als 10 Ohm*cm, bevorzugt weniger als 1 Ohm*cm beträgt.

**14.** Sputtertarget nach einem der vorhergehenden Ansprüche 11 bis 13, **dadurch gekennzeichnet, dass** die metallische Beimischung ein oder mehrere Elemente aus der Gruppe Nb, Ti, Mo, W, Ta, V enthält.

**15.** Sputtertarget nach Anspruch 14, **dadurch gekennzeichnet, dass** die metallische Beimischung mindestens 50 %, vorzugsweise mindestens 70 % des Sauerstoffmangels ausmacht.

**16.** Sputtertarget nach Anspruch 14 oder 15, **dadurch gekennzeichnet, dass** es Nb und Mo sowie Nioboxid mit unterstöchiometrischem Sauerstoffgehalt enthält.

**17.** Sputtertarget nach Anspruch 16, **dadurch gekennzeichnet, dass** es aus $Nb_2O_{5-x}$ und Mo besteht mit x=0,01 - 0,3, wobei der Mo-Gehalt vorzugsweise zwischen 28 und 60 Gew.-%, bevorzugt zwischen 36 und 50 Gew.-%, beträgt.

**18.** Sputtertarget nach Anspruch 14 oder 15, **dadurch gekennzeichnet, dass** es Ti und Mo sowie mindestens eines deren Oxide enthält, wobei der Mo-Gehalt zwischen 30 und 65 Gew.-%, bevorzugt zwischen 40 und 55 Gew.-%, beträgt.

**19.** Sputtertarget nach Anspruch 12, **dadurch gekennzeichnet, dass** der Reduktionsgrad an mindestens 5 Stellen über die Dicke des Sputtertargets gemessen um nicht mehr als +-5 % (relativ) um einen Mittelwert streut.

**20.** Sputtertarget nach einem der vorhergehenden Ansprüche 11 bis 19, **dadurch gekennzeichnet, dass** die metallische Beimischung einen Metallgehalt definiert, der an mindestens 5 Stellen über die Dicke des Sputtertargets gemessen um nicht mehr als +-5 % um einen Mittelwert streut.

**21.** Verfahren zur Herstellung eines Schichtsystems nach einem der Ansprüche 1 bis 10, umfassend die Abscheidung einer Antireflexschicht und die Abscheidung einer Absorberschicht durch DC- oder MF-Sputtern eines Sputtertargets in einer Sputter-Atmosphäre, die ein Edelgas enthält, **dadurch gekennzeichnet, dass** ein Sputtertarget nach einem oder mehreren der Ansprüche 11 bis 20 mit einem Sauerstoffmangel eingesetzt wird, und dass zur Abscheidung einer Absorberschicht aus einem Oxid oder aus einem Oxinitrid mit unterstöchiometrischem Sauerstoffgehalt der Sputter-Atmosphäre ein Reaktivgas in Form von Sauerstoff und/oder Stickstoff beigemischt wird, derart, dass sich in der Sputter-Atmosphäre ein Reaktivgasgehalt von maximal 10 Vol.-%, bevorzugt maximal 5 Vol.-% einstellt.

**22.** Verfahren nach Anspruch 21, **dadurch gekennzeichnet, dass** - jeweils bezogen auf eine voll-stöchiometrische Schicht - sich der Anteil an Sauerstoff und Stickstoff im Material des Sputtertargets vom Anteil an Sauerstoff und Stickstoff im Oxid oder Oxinitrid der Absorberschicht nicht oder um maximal +-20%, bevorzugt um maximal +/-10%, unterscheidet.

**23.** Verfahren nach Anspruch 21 oder 22, **dadurch gekennzeichnet, dass** die Abscheidung der Antireflexschicht und der Absorberschicht unter Einsatz derselben Target-Zusammensetzung erfolgt, wobei die Sputter-Atmosphäre bei der Abscheidung der Antireflexschicht einen höheren Reaktivgasgehalt hat als bei der Abscheidung der Absorberschicht.

**Claims**

**1.** A light absorbing layer system formed from at least two layers on a carrier (3), one of which layers is an anti-reflection layer (S1), which consists of a dielectric material, and at least one further layer is an absorber layer (S2) formed from an oxide or from an oxynitride with sub-stoichiometric oxygen content, wherein the layer system as a whole in the wavelength range of from 380 to 780 nm has a visual transmission Tv of less than 20% and a visual reflection Rv of less than 6%,
**characterised in that**
the layer system has a layer resistance RY of more than 10 k ohm.

**2.** The layer system according to claim 1, **characterised in that** the layer system as a whole in the wavelength range of from 380 to 780 nm has a visual transmission Tv of less than 10%, a visual reflection Rv of less than 2% and a layer resistance RY of more than 20 k ohm.

3. The layer system according to claim 1 or 2, **characterised in that** the absorber layer contains, as main component, oxides of the metals Nb, Ti, Mo, W, V or mixtures thereof.

4. The layer system according to any one of the preceding claims, **characterised in that** the anti-reflection layer contains, as main component, $Nb_2O_5$, $TiO_2$, $MoO_3$, $WO_3$, $V_2O_5$, AlN, $SnO_2$, ZnO, $Si_3N_4$, $HfO_2$, $Al_2O_3$, silicon oxynitride or mixtures thereof, and **in that** it is applied directly or indirectly to a substrate formed from light-permeable material and has a refractive index $n_R$ for which: $n_S < n_R < n_A$, wherein $n_S$ is the refractive index of the substrate and $n_A$ is the refractive index of the absorber layer, wherein the oxygen content of the anti-reflection layer is at least 94% of the stoichiometric oxygen content.

5. The layer system according to any one of the preceding claims, **characterised by** a kappa absorption index in the range of from 0.7 to 0.8 at a wavelength of 550 nm.

6. The layer system according to any one of the preceding claims, **characterised in that** the oxygen content of the absorber layer is between 65 and 90%, preferably between 70 and 85% of the stoichiometric oxygen content.

7. The layer system according to any one of the preceding claims, **characterised in that** the absorber layer has an optically homogeneous structure in the sense that it does not comprise any crystalline structures detectable by means of X-ray diffractometer measurements.

8. The layer system according to any one of the preceding claims, **characterised in that** the absorber layer has a thickness of less than 250 nm, preferably in the range of from 70 to 160 nm.

9. The layer system according to any one of the preceding claims, **characterised in that** the anti-reflection layer has a thickness of less than 50 nm, preferably in the range of from 30 to 45 nm.

10. The layer system according to any one of the preceding claims, **characterised in that** the overall thickness of anti-reflection layer and absorber layer lies in the range of from 80 to 300 nm, preferably in the range of from 100 to 200 nm.

11. A sputtering target for producing a layer system according to any one of claims 1 to 10, **characterised in that** it has an oxygen deficiency that is established by a reduced oxide phase of sub-stoichiometric and thus electrically conductive oxide or oxynitride based on $Nb_2O_{5-x}$, $TiO_{2-x}$, $MoO_{3-x}$, $WO_{3-x}$, $V_2O_{5-x}$ (x>0) or mixtures thereof together with a metal admixture, wherein the sputtering target contains either Nb and Mo and at least one of the oxides thereof, or contains Ti and Mo as well as at least one of the oxides thereof.

12. The sputtering target according to claim 11, **characterised in that** the oxygen deficiency is defined by a degree of reduction at which the oxygen content is between 65 and 90%, preferably between 70 and 85% of the stoichiometric oxygen content.

13. The sputtering target according to claim 11 or 12, **characterised in that** its electrical resistance is less than 10 ohm*cm, preferably less than 1 ohm*cm.

14. The sputtering target according to any one of preceding claims 11 to 13, **characterised in that** the metallic admixture contains one or more elements from the group Nb, Ti, Mo, W, Ta, V.

15. The sputtering target according to claim 14, **characterised in that** the metallic admixture accounts for at least 50%, preferably at least 70% of the oxygen deficiency.

16. The sputtering target according to claim 14 or 15, **characterised in that** it contains Nb and Mo as well as niobium oxide with sub-stoichiometric oxygen content.

17. The sputtering target according to claim 16, **characterised in that** it consists of $Nb_2O_{5-x}$ and Mo, with x = 0.01 - 0.3, wherein the Mo content is preferably between 28 and 60 % by weight, preferably between 36 and 50 % by weight.

18. The sputtering target according to claim 14 or 15, **characterised in that** it contains Ti and Mo as well as at least one of the oxides thereof, wherein the Mo content is between 30 and 65 % by weight, preferably between 40 and 55 % by weight.

19. The sputtering target according to claim 12, **characterised in that** the degree of reduction measured at least at 5 points over the thickness of the sputtering target spreads by no more than ±5% (relative) around the mean value.

20. The sputtering target according to any one of preceding claims 11 to 19, **characterised in that** the metallic admixture defines a metal content which, measured at least at 5 points over the thickness of the sputtering target, spreads by no more than ±5% around a mean value.

21. A method for producing a layer system according to any one of claims 1 to 10, comprising the deposition of an anti-reflection layer and the deposition of an absorber layer by DC or MF sputtering of a sputtering target in a sputtering atmosphere that contains a noble gas, **characterised in that** a sputtering target according to any one or more of claims 11 to 20 having an oxygen deficiency is used, and **in that**, in order to deposit an absorber layer formed from an oxide or from an oxynitride having a sub-stoichiometric oxygen content, a reactive gas in the form of oxygen and/or nitrogen is admixed to the sputtering atmosphere, in such a way that a reactive gas content of at most 10 vol. %, preferably at most 5 vol. %, is established in the sputtering atmosphere.

22. The method according to claim 21, **characterised in that** - in each case based on a fully stoichiometric layer - the proportion of oxygen and nitrogen in the material of the sputtering target does not differ from the proportion of oxygen and nitrogen in the oxide or oxynitride of the absorber layer or differs by at most ±20%, preferably by at most ±10%.

23. The method according to claim 21 or 22, **characterised in that** the anti-reflection layer and the absorber layer are deposited with use of the same target composition, wherein the sputtering atmosphere at the time of deposition of the anti-reflection layer has a higher reactive gas content than at the time of deposition of the absorber layer.

## Revendications

1. Système de couches absorbant la lumière, constitué d'au moins deux couches sur un support (3), dont une couche est une couche antiréfléchissante (S1), qui est constituée d'un matériau diélectrique, et dont au moins une autre est une couche absorbante (S2) d'un oxyde ou d'un oxynitrure ayant une teneur sous-stoechiométrique en oxygène, le système de couches présentant globalement, dans la gamme de longueurs d'onde de 380 à 780 nm, un facteur de transmission dans le visible Tv inférieur à 20 %, un facteur de réflexion dans le visible Rv inférieur à 6 %, **caractérisé en ce que** le système de couches présente une résistance de feuille RY supérieure à 10 k Ohm.

2. Système de couches selon la revendication 1, **caractérisé en ce que** le système de couches présente globalement dans la gamme de longueurs d'onde de 380 à 780 nm un facteur de transmission dans le visible Tv inférieur à 10 %, un facteur de réflexion dans le visible Rv inférieur à 2 % et une résistance de feuille RY supérieure à 20 k Ohm.

3. Système de couches selon la revendication 1 ou 2, **caractérisé en ce que** la couche absorbante contient en tant que composant principal des oxydes des métaux Nb, Ti, Mo, W, V ou des mélanges de ceux-ci.

4. Système de couches selon l'une des revendications précédentes, **caractérisé en ce que** la couche antiréfléchissante contient en tant que composant principal du $Nb_2O_5$, du $TiO_2$, du $MoO_3$, du $WO_3$, du $V_2O_5$, de l'AlN, du $SnO_2$, du ZnO, du $Si_3N_4$, du $HfO_2$, de l'$Al_2O_3$, de l'oxynitrure de silicium ou des mélanges de ceux-ci, ou qu'elle est appliquée directement ou indirectement sur un substrat en un matériau translucide et présente un indice de réfraction $n_R$ tel que $n_S < n_R < n_A$, où $n_S$ est l'indice de réfraction du substrat et $n_A$ est l'indice de réfraction de la couche absorbante, la teneur en oxygène de la couche antiréfléchissante étant d'au moins 94 % de la teneur stoechiométrique en oxygène.

5. Système de couches selon l'une des revendications précédentes, **caractérisé par** un indice d'absorption kappa compris dans la plage de 0,7 à 0,8 pour une longueur d'onde de 550 nm.

6. Système de couches selon l'une des revendications précédentes, **caractérisé en ce que** la teneur en oxygène de la couche absorbante est comprise entre 65 et 90 %, de préférence entre 70 et 85 % de la teneur stoechiométrique en oxygène.

7. Système de couches selon l'une des revendications précédentes, **caractérisé en ce que** la couche absorbante a une structure optiquement homogène, en ce sens qu'elle ne présente aucune structure cristalline pouvant être détectée par des mesures par diffraction aux rayons X.

**8.** Système de couches selon l'une des revendications précédentes, **caractérisé en ce que** la couche absorbante a une épaisseur inférieure à 250 nm, de préférence comprise dans la plage de 70 à 160 nm.

**9.** Système de couches selon l'une des revendications précédentes, **caractérisé en ce que** la couche antiréfléchissante a une épaisseur inférieure à 50 nm, de préférence comprise dans la plage de 30 à 45 nm.

**10.** Système de couches selon l'une des revendications précédentes, **caractérisé en ce que** l'épaisseur totale de la couche antiréfléchissante et de la couche absorbante est comprise dans la plage de 80 à 300 nm, de préférence dans la plage de 100 à 200 nm.

**11.** Cible de pulvérisation cathodique pour la fabrication d'un système de couches selon l'une des revendications 1 à 10, **caractérisée en ce qu'**elle présente un déficit en oxygène qui est ajusté par une phase oxyde réduite d'oxyde ou d'oxynitrure sous-stoechiométrique et donc électriquement conducteur, à base de $Nb_2O_{5-x}$, de $TiO_{2-x}$, de $MoO_{3-x}$, de $WO_{3-x}$, de $V_2O_{5-x}$ (x>0) ou de mélanges de ceux-ci, ensemble avec un additif métallique, la cible de pulvérisation cathodique contenant soit du Nb et du Mo ainsi qu'au moins l'un de leurs oxydes, soit du Ti et du Mo ainsi qu'au moins l'un de leurs oxydes.

**12.** Cible de pulvérisation cathodique selon la revendication 11, **caractérisée en ce que** le déficit en oxygène est défini par un degré de réduction pour lequel la teneur en oxygène est compris entre 65 et 90 %, de préférence entre 70 et 85 % de la teneur stoechiométrique en oxygène.

**13.** Cible de pulvérisation cathodique selon la revendication 11 ou 12, **caractérisée en ce que** sa résistance électrique est inférieure à 10 Ohm*cm, de préférence inférieure à 1 Ohm*cm.

**14.** Cible de pulvérisation cathodique selon l'une des revendications précédentes 11 à 13, **caractérisée en ce que** l'additif métallique contient un ou plusieurs éléments du groupe Nb, Ti, Mo, W, Ta, V.

**15.** Cible de pulvérisation cathodique selon la revendication 14, **caractérisée en ce que** l'additif métallique représente au moins 50 %, de préférence au moins 70 % du déficit en oxygène.

**16.** Cible de pulvérisation cathodique selon la revendication 14 ou 15, **caractérisée en ce qu'**elle contient du Nb et du Mo, ainsi que de l'oxyde de niobium présentant une teneur sous-stoechiométrique en oxygène.

**17.** Cible de pulvérisation cathodique selon la revendication 16, **caractérisée en ce qu'**elle est constituée de $Nb_2O_{5-x}$ et de Mo, avec x = 0,01 à 0,3, la teneur en Mo étant de préférence comprise entre 28 et 60 % en poids, de préférence entre 36 et 50 % en poids.

**18.** Cible de pulvérisation cathodique selon la revendication 14 ou 15, **caractérisée en ce qu'**elle contient du Ti et du Mo ainsi qu'au moins l'un de leurs oxydes, la teneur en Mo étant comprise entre 30 et 65 % en poids, de préférence entre 40 et 55 % en poids.

**19.** Cible de pulvérisation cathodique selon la revendication 12, **caractérisée en ce que** le degré de réduction, mesuré en au moins 5 points sur l'épaisseur de la cible de pulvérisation cathodique, présente une dispersion non supérieure à $\pm$ 5 % (en valeur relative) autour d'une valeur moyenne.

**20.** Cible de pulvérisation cathodique selon l'une des revendications précédentes 11 à 19, **caractérisée en ce que** l'additif métallique définit une teneur en métal qui, mesurée en au moins 5 points sur l'épaisseur de la cible de pulvérisation cathodique, présente une dispersion non supérieure à $\pm$ 5 % autour d'une valeur moyenne.

**21.** Procédé de fabrication d'un système de couches selon l'une des revendications 1 à 10, comprenant le dépôt d'une couche antiréfléchissante et le dépôt d'une couche absorbante, par pulvérisation cathodique en courant continu ou à moyenne fréquence d'une cible de pulvérisation cathodique dans une atmosphère de pulvérisation cathodique qui contient un gaz rare, **caractérisé en ce qu'**on utilise une cible de pulvérisation cathodique selon l'une ou plusieurs des revendications 11 à 20 présentant un déficit en oxygène, et que, pour le dépôt d'une couche absorbante d'un oxyde ou d'un oxynitrure présentant une teneur sous-stoechiométrique en oxygène de l'atmosphère de pulvérisation cathodique, on ajoute un gaz réactif sous forme d'oxygène et/ou d'azote de telle sorte qu'il s'ajuste dans l'atmosphère de pulvérisation cathodique une teneur en gaz réactif au maximum de 10 % en volume, de préférence au maximum de 5 % en volume.

**22.** Procédé selon la revendication 21, **caractérisé en ce que** - dans chaque cas pour une couche entièrement stoechiométrique - la teneur en oxygène et en azote du matériau de la cible de pulvérisation cathodique ne diffère pas de la teneur en oxygène et en azote de l'oxyde ou de l'oxynitrure de la couche absorbante, ou en diffère au maximum de ± 20 %, de préférence au maximum de ± 10 %.

**23.** Procédé selon la revendication 21 ou 22, **caractérisé en ce que** le dépôt de la couche antiréfléchissante et de la couche absorbante a lieu par utilisation de la même composition de cible, l'atmosphère de pulvérisation cathodique présentant, lors du dépôt de la couche antiréfléchissante, une teneur en gaz réactif plus élevée que lors du dépôt de la couche absorbante.

Fig. 1

Fig. 2

HD-2300A 200kV x450k TE 12/05/16 15:06          60.0nm

Fig. 3

**Fig. 4**

**Fig. 5**

**Fig. 6**

**Fig. 7**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 2336811 A

- EP 0852266 A